# EUROPEAN PATENT SPECIFICATION

(11) **EP 2 693 496 B1**
(45) Date of publication and mention of the grant of the patent: **02.08.2017**
(21) Application number: 13761496.2
(22) Date of filing: 06.03.2013
(51) Int. Cl.: H01L 31/18, H01L 31/0749, H01L 31/042

(54) **METHOD FOR MANUFACTURING CIGS THIN-FILM SOLAR CELLS USING SUBSTRATES NOT CONTAINING SODIUM**
VERFAHREN ZUR HERSTELLUNG VON CIGS-DÜNNSCHICHTSOLARZELLEN UNTER VERWENDUNG NICHT-NATRIUM-HALTIGER SUBSTRATE
PROCÉDÉ DE FABRICATION DE CELLULES SOLAIRES À COUCHE MINCE EN CIGS UTILISANT DES SUBSTRATS NE CONTENANT PAS DE SODIUM

(30) Priority: 12.03.2012 KR 20120025153; 28.01.2013 KR 20130009174
(43) Date of publication of application: 05.02.2014
(73) Proprietor: Korea Institute of Energy Research, Daejeon 305-343 (KR)
(72) Inventor: EO, Young-Joo, Daejeon 305-509 (KR); YOON, Kyung-Hoon, Daejeon 305-340 (KR); AHN, SeJin, Daejeon 305-768 (KR); GWAK, Jihye, Daejeon 302-120 (KR); YUN, Jae-Ho, Daejeon 301-150 (KR); CHO, Ara, Seoul 151-050 (KR); SHIN, Kee-Shik, Daejeon 305-762 (KR); AHN, SeoungKyu, Daejeon 305-807 (KR); CHO, Jun-Sik, Daejeon 305-768 (KR); YOO, Jin-Su, Seoul 139-957 (KR); PARK, Sang-Hyun, Daejeon 305-750 (KR); PARK, Joo-Hyung, Daejeon 305-330 (KR)
(74) Representative: Chas. Hude A/S
(86) International application number: PCT/KR2013/001808
(87) International publication number: WO 2013/137587

(56) References cited:
- JP-A- 2003 318 424
- JP-A- 2004 047 860
- JP-A- 2004 047 860
- KR-A- 20110 066 260
- KR-B1- 100 743 923
- US-A- 5 626 688
- US-A1- 2005 028 861
- US-A1- 2009 145 482
- US-A1- 2012 006 403

## Description

### BACKGROUND OF THE INVENTION

### 1. Technical Field

The present invention relates to a method of manufacturing CIGS-based thin-film solar cell using Na-free substrate, and CIGS-based thin-film solar cell manufactured thereby. More particularly, the present invention relates to a method of manufacturing CIGS-based thin-film solar cell, in which Na supply sources are formed on parts of the surface of molybdenum electrode prior to the formation of CIGS-based precursor thin film and then heat-treated to form CIGS-based thin film, and Na is diffused in the CIGS-based thin film, thereby improving the electrical characteristics of the CIGS-based thin film serving as a light-absorbing layer of a solar cell, and to CIGS-based thin-film solar cell manufactured using the method.

### 2. Description of the Related Art

Solar cells are classified according to the materials used in light-absorbing layers. Among these solar cells, silicon solar cells are most frequently used. However, the price of silicon solar cells has rapidly increased due to a supply shortage of silicon, and thus thin-film solar cells have recently attracted considerable attention. A thin-film solar cell is used in a wide range of fields because it is thin to reduce its raw material consumption and is lightweight. Therefore, research into thin-film solar cell's raw materials such as amorphous silicon, CdTe, CIS and CIGS has been actively conducted.

A CIS-based or CIGS-based thin film is one of group I-III-VI compound semiconductors, and exhibits the highest conversion efficiency (20.3%) among lab-made thin films. Particularly, since a CIS-based or CIGS-based thin film is characterized in that it can be formed to a thickness of 10 µm or less and is stable even in long-term use, it is expected that it will be used in manufacturing low-priced high-efficiency solar cells that can replace silicon solar cells.

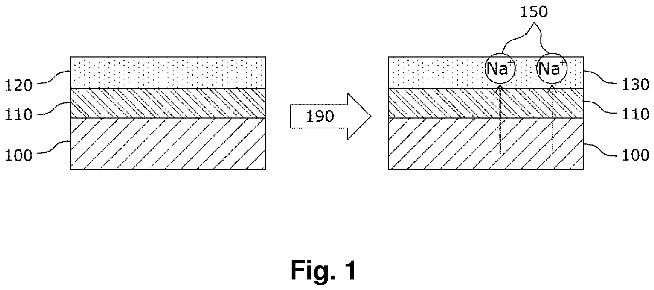

CIGS-based thin film was developed in order to improve the low open voltage of a CIS-based thin film, and is a material prepared by replacing a part of In with Ga or replacing S with Se. As shown in FIG. 1, CIGS-based thin film 130 is generally prepared by forming molybdenum electrode 110 on a soda-lime glass substrate 100, forming CIGS-based precursor thin film 120 on the molybdenum electrode 110 and then performing a selenization process. In this case, it was found that, during the selenization process, Na ions existing in the soda-lime glass substrate 100 are diffused into the CIGS-based thin film 130, thus improving the electrical characteristics of the device. However, it is impossible to control the diffusion of Na ions into the CIGS-based thin film 130. Therefore, in order to control the diffusion of Na ions, an anti-diffusion layer for preventing the diffusion of Na ions into the CIGS-based thin film 130 from the soda-lime glass substrate 100 must be used, or Na supply sources must be additionally applied on the soda-lime glass substrate 100.

Currently, various lines of research into supplying Na to a light-absorbing layer of a solar cell are being conducted. For example, Korean Patent No. 743,923 discloses a technology of supplying Na into CIGS-based thin film by doping a molybdenum electrode with Na. However, this technology is problematic in that the amount of Na necessary for doping molybdenum is restricted and that the electrical characteristics (conductivity) of molybdenum are deteriorated by the addition of Na.

Further, Korean Patent No. 1,062,180 discloses a technology of manufacturing a solar cell by forming a light-absorbing layer, supplying an aqueous Na solution to the light-absorbing layer, drying the solution to form a Na-containing coating film on the surface of the light-absorbing layer and then heat-treating the coating film to diffuse Na into the light-absorbing layer. However, this technology is also problematic in that the supply of Na after the formation of a light-absorbing layer makes it difficult to uniformly diffuse Na into the light-absorbing layer and needs an additional thermal process, which results in lengthening the overall process.

JP 2004 047860 describes a method of manufacturing a CIGS-based thin-film solar cell. However, in contrast to the present invention there is no use of a mask and sodium halide is not used as a sodium source.

### SUMMARY OF THE INVENTION

Accordingly, the present invention has been devised to solve the above-mentioned problems, and an object of the present invention is to provide a method of manufacturing CIGS-based thin-film solar cell, wherein Na halide sources are applied onto the parts of the surface of molybdenum electrode using a mask in a a vacuum chamber prior to the formation of CIGS-based precursor thin film, and then heat treatment is conducted to form CIGS-based thin film, thus resulting in Na being diffused into the CIGS-based thin film, thereby improving the efficiency of a solar cell including the CIGS-based thin film serving as a light-absorbing layer.

In order to accomplish the above object, an aspect of the present invention provides a method of manufacturing CIGS-based thin-film solar cell, including the steps of: forming molybdenum electrode on Na-free substrate (S1); forming Na supply sources on parts of the surface of the molybdenum electrode (S2); forming CIGS-based precursor thin film on the molybdenum electrode (S3); and heat-treating the CIGS-based precursor thin film with selenium to diffuse Na from the Na supply sources into the CIGS-based precursor thin film, thus forming CIGS-based thin film (S4), characterized in that in step (S2) the Na supply sources are sodium halide formed on a part of the molybdenium electrode using a mask in a vacuum chamber.

The Na-free substrate used in the step S1 of the method may be a polymer substrate selected from the group consisting of polyimide (PI), polyethylene terephthalate (PET), polyethylene naphthalate (PEN), polyether sulfone (PES) and aromatic polyester (liquid crystal polymer); a stainless steel (STS) substrate; a Na-free glass substrate (Corning 7059 Glass or Corning 1737 Glass); or a ceramic substrate.

In the step (S2), a solution containing a Na supply sources may be selectively applied and then dried. Here, the solution may be applied by spray coating, ink-jet printing or spin coating using a mask.

In the step (S2), the Na supply sources may be formed on a part of the surface of the molybdenum electrode using a mask in a vacuum chamber. Here, the Na supply sources may be formed by sputtering, electron-beam deposition or evaporation in a vacuum chamber.

In the step (S2), the Na supply sources may be sodium halide.

The sodium halide may be selected from the group consisting of NaF, NaCl, NaBr and NaI.

In the step (S3), the CIGS-based precursor thin film may be formed by any one non-vacuum coating selected from the group consisting of spraying, ultrasonic spraying, spin coating, a doctor blade method, screen printing and ink-jet printing, or may be formed by any one vacuum coating selected from group consisting of sputtering, simultaneous sputtering and evaporation.

In the step (S4), the heat treatment with selenium may be performed at a temperature of 250 ∼ 600°C for 30 ∼ 120 minutes under a selenium atmosphere.

Another aspect provides CIGS-based thin-film solar cell, including: Na-free substrate; molybdenum electrode formed on the Na-free substrate; CIGS-based thin film formed on the molybdenum electrode and containing Na, Na being diffused from Na supply sources formed on parts of the surface of the molybdenum electrode; buffer layer formed on the CIGS-based thin film; front electrode formed on the buffer layer; and auxiliary electrode formed on the front electrode.

Here, the CIGS-based thin film contains Na diffused from Na supply sources formed on parts of the surface of the molybdenum electrode.

Still another aspect provides CIGS-based thin-film solar cell module, including a plurality of CIGS-based thin-film solar cells, each including: Na-free substrate; molybdenum electrode formed on the Na-free substrate; CIGS-based thin film formed on the molybdenum electrode and containing Na, Na being diffused from Na supply sources formed on parts of the surface of the molybdenum electrode; buffer layer formed on the CIGS-based thin film; and front electrode formed on the buffer layer.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a schematic sectional view showing a conventional method of preparing CIGS-based thin film;
FIG. 2 is a schematic flowchart showing a method of manufacturing CIGS-based thin-film solar cell according to an embodiment of the present invention; and
FIG. 3 is a schematic sectional view showing a method of manufacturing CIGS-based thin-film solar cell according to an embodiment of the present invention.
FIG. 4 is a graph showing electrical property of CIGS-based thin-films of present invention and prior art.

### [Reference Numerals]

- 100:: soda-lime glass substrate
- 300:: Na-free substrate
- 110, 310:: Mo electrode
- 120, 320:: CIGS precursor
- 130, 330:: CIGS thin film
- 150, 350:: Na ion
- 340:: Na supply sources
- 190:: heat treatment (selenization process)

### DESCRIPTION OF THE PREFERRED EMBODIMENTS

Hereinafter, preferred embodiments of the present invention will be described in detail with reference to the attached drawings.

The present invention provides a method of manufacturing CIGS-based thin-film solar cell, wherein Na-free substrate is used instead of a soda-lime substrate in order to prevent the random diffusion of Na into a molybdenum electrode and a light-absorbing layer, and Na supply sources are additionally formed on the parts of surface of molybdenum electrode, and CIGS-based precursor thin film is formed on the Na supply sources and then heat-treated with selenium to form CIGS-based thin film, and Na is diffused in the CIGS-based thin film, thereby improving the electrical characteristics of the CIGS-based thin-film solar cell.

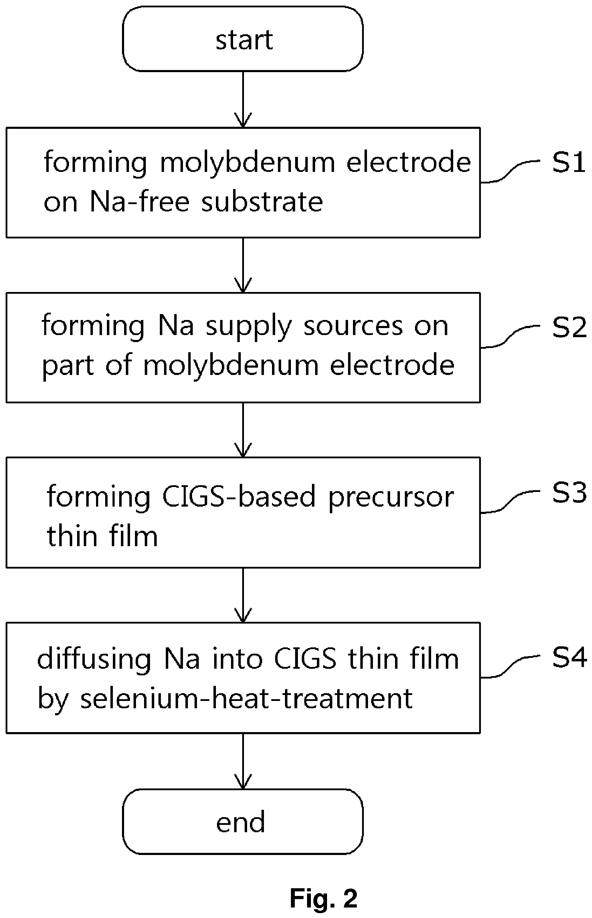

Hereinafter, a method of manufacturing CIGS-based thin-film solar cell according to the present invention will be described in detail with reference to FIG. 2. This method essentially includes four steps.

First, a molybdenum electrode is formed on Na-free substrate (S1). The molybdenum electrode may be formed on the Na-free substrate by a method commonly known in the related field. The "Na-free substrate" is a substrate having a Na content of less than 0.3%, and preferably 0%. The Na-free substrate may be a polymer substrate selected from the group consisting of polyimide (PI), polyethylene terephthalate (PET), polyethylene naphthalate (PEN), polyether sulfone (PES) and aromatic polyester (liquid crystal polymer); a stainless steel (STS) substrate; a Na-free glass substrate (Corning 7059 Glass or Corning 1737 Glass); or a ceramic substrate. Preferably, the Na-free substrate may be a stainless steel substrate.

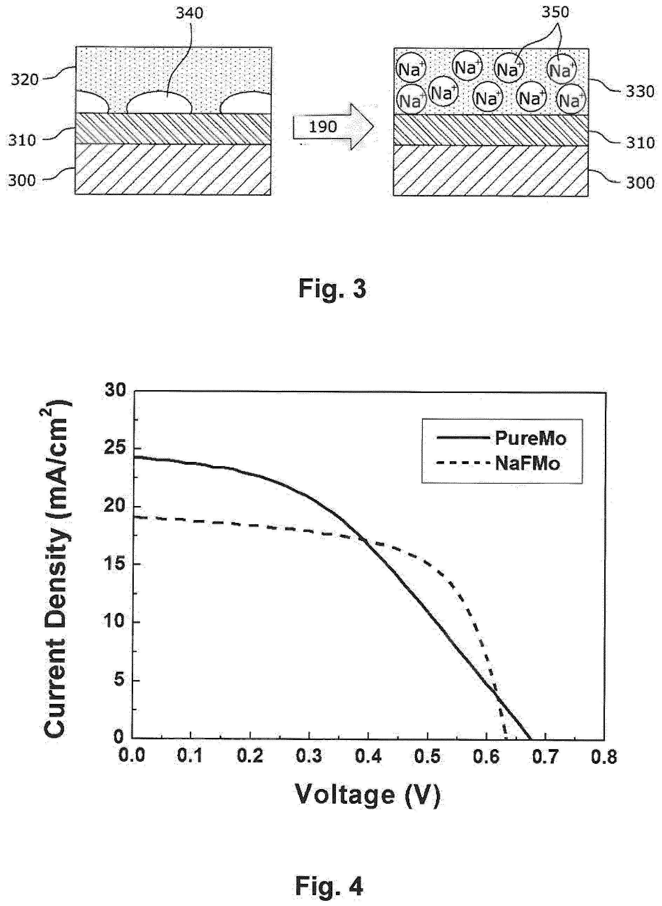

Subsequently, Na supply sources are formed on parts of the surface of the molybdenum electrode (S2). As shown in FIG. 3, it is important that the Na supply sources are formed on parts of the surface of the molybdenum electrode. The reason for this is that, when the Na supply sources entirely covers the molybdenum electrode, the contact between the CIGS-based thin film and the molybdenum electrode becomes poor, thus influencing the electrical characteristics of a device.

In the step (S2), according to an aspect of the present disclosure not forming part of the claimed invention the Na supply sources may be formed by selectively applying a solution containing a Na supply sources and then drying the solution, that is, it may be formed by a wet process. For example, the Na supply sources may be formed on parts of the surface of the molybdenum electrode by selectively applying the solution onto the surface of the molybdenum electrode and then drying the solution using spin coating or the like using a mask. According to the invention as defined in the claims, in the step (S2), the Na supply sources are formed on parts of the surface of the molybdenum electrode using a mask in a vacuum chamber, that is, the Na supply sources are formed by a dry process. For example, the Na supply sources may be formed on parts of the surface of the molybdenum electrode by sputtering, electron-beam deposition or evaporation in a vacuum chamber. Here, all deposition methods may be used without limitation.

As such, those skilled in the art may appropriately select a wet process or a dry process according to the kind of a Na supply sources.

In the step (S2), the Na supply sources may be sodium halide. Here, examples of the sodium halide may include NaF, NaCl, NaBr and NaI. Subsequently, CIGS-based precursor thin film is formed on the molybdenum electrode (S3). The CIGS-based precursor thin film may be formed on the molybdenum electrode by a method commonly known in the related field. For example, the CIGS-based precursor thin film may be formed by any one non-vacuum coating selected from group consisting of spraying, ultrasonic spraying, spin coating, a doctor blade method, screen printing and ink-jet printing, or may be formed by any one vacuum coating selected from group consisting of sputtering, simultaneous sputtering and evaporation..

The CIGS-based thin film may be: a 4-component compound thin film of Cu-In-Ga-Se; a 5-component compound including at least one selected from the group consisting of Cu-In-Ga-Se-(S,Se) and Cu-In-Al-Ga-(S,Se); or a 6-component compound thin film of Cu-In-Al-Ga-Se-S.

Subsequently, heat treatment with selenium is performed to allow Na in the Na supply sources to be diffused into the CIGS-based thin film (S4). In the step (S4), thanks to the heat treatment with selenium, the CIGS-based precursor thin film may be formed into the CIGS-based thin film, and Na may be diffused into the CIGS-based film. In this step, the heat treatment with selenium may be performed by heating solid selenium to form selenium vapor and then supplying the selenium vapor to the solar cell to increase the temperature thereof. Preferably, the heat treatment with selenium may be performed at a temperature of 250 ∼ 600°C for 30 ∼ 120 minutes under a selenium atmosphere. When the heat treatment with selenium is performed at the above temperature range, crystallization is sufficiently conducted, thus improving the characteristics of the CIGS-based thin film.

If necessary, several steps may be performed even after the step S4. For example, since differences in lattice constant and energy bandgap between a light-absorbing layer and a front electrode are large, for the purpose of excellent electrical connection between the light-absorbing layer and the front electrode, a buffer layer, its energy bandgap being positioned between the energy band gap of the light-absorbing layer and the energy bandgap of the front electrode, may be formed. In this case, a cadmium sulfide layer may be used as the buffer layer, and may be formed by chemical bath deposition (CBD). Besides, an InₓSe_{y} layer may also be used as the buffer layer. Further, the front electrode may be made of a material having high transmittance, such as ZnO, ITO, IZO, or In₂O₃. The front electrode may have a multi-layer structure as well as a single-layer structure. If necessary, the resistance of the front electrode may be lowered by doping the front electrode with aluminum, boron or the like. Such a front electrode may be formed by sputtering or the like. After the formation of the front electrode, if necessary, an auxiliary electrode for collecting electric current may be formed. Such an auxiliary electrode may be made of aluminum and/or nickel. Since the auxiliary electrode is disposed on the front electrode in the shape of a grid, light reaches the light absorbing layer through the front electrode.

Also described but not forming part of the invention is CIGS-based thin-film solar cell, including: Na-free substrate; molybdenum electrode formed on the Na-free substrate; CIGS-based thin film formed on the molybdenum electrode and containing Na, Na being diffused from Na supply sources formed on parts of the surface of the molybdenum electrode; buffer layer formed on the CIGS-based thin film; front electrode formed on the buffer layer; and auxiliary electrode formed on the front electrode. Further described and not forming part of the invention is a CIGS-based thin-film solar cell module, including a plurality of CIGS-based thin-film solar cells, wherein each of the CIGS-based thin-film solar cells includes: Na-free substrate; molybdenum electrode formed on the Na-free substrate; CIGS-based thin film formed on the molybdenum electrode and containing Na, Na being diffused from Na supply sources formed on parts of the surface of the molybdenum electrode; buffer layer formed on the CIGS-based thin film; and front electrode formed on the buffer layer.

The present invention will be described in more detail with reference to the following Example.

### [Example 1]

A Mo electrode was formed on a stainless steel (STS) substrate as Na-free substrate by sputtering. Subsequently, a shadow mask having a pitch of 1 mm and a line width of 500 µm was provided on the Mo electrode, and then a NaF film was formed on a part of the Mo electrode using thermal evaporator. Regions (500 µm) being provided with a NaF film and regions (500 µm) not being provided with a NaF film were formed using the shadow mask such that they are adjacent to each other and are regularly repeated. The thickness of the NaF film was 50 nm.

After the formation of the NaF film, the shadow mask was removed, a CIGS thin film was formed on the Mo electrode deposited with NaF by a non-vacuum method, and then the characteristics of the CIGS thin film were measured.

As a control group, a CIGS cell was formed on the Mo electrode not deposited with NaF, and then characteristics of the CIGS cell were measured. The results thereof are shown in Table 1 below and FIG. 4.

**[Table 1]**

| Class. | Voc (V) | Jsc (mA/cm²) | FF (%) | Efficiency (%) |
|---|---|---|---|---|
| Pure Mo | 0.67 | 24.25 | 40.97 | 6.72 |
| NaFMo | 0.63 | 19.10 | 62.53 | 7.58 |

From Table 1 and FIG. 4, it can be ascertained that the efficiency of the CIGS cell formed on the Mo electrode deposited with NaF is higher than that of the CIGS cell formed on the Mo electrode not deposited with NaF.

The method of manufacturing CIGS-based thin-film solar cell according to the present invention is advantageous in that the random diffusion of Na existing in a substrate can be prevented due to using Na-free substrate, and that Na is supplied into CIGS-based thin film serving as a light-absorbing layer of a solar cell by additional Na supply sources, thus improving the efficiency of a solar cell.

## Claims

1. A method of manufacturing CIGS-based thin-film solar cell, comprising the steps of:
forming molybdenum electrode on Na-free substrate (S1);
forming Na supply sources on parts of the surface of the molybdenum electrode (S2);
forming CIGS-based precursor thin film on the molybdenum electrode (S3); and
heat-treating the CIGS-based precursor thin film with selenium to diffuse Na from the Na supply sources into the CIGS-based precursor thin film, thus forming CIGS-based thin film (S4),
**characterized in that** in the step (S2), the Na supply sources are sodium halide formed on a part of the molybdenium electrode using a mask in a vacuum chamber.

2. The method of claim 1, wherein, in the step S1, the Na-free substrate is a polymer substrate selected from the group consisting of polyimide (PI), polyethylene terephthalate (PET), polyethylene naphthalate (PEN), polyether sulfone (PES) and aromatic polyester; a stainless steel (STS) substrate; a Na-free glass substrate; or a ceramic substrate.

3. The method of claim 1, wherein the sodium halide is selected from the group consisting of NaF, NaCl, NaBr and NaI.

4. The method of claim 1, wherein, in the step (S3), the CIGS-based precursor thin film is formed by any one non-vacuum coating selected from the group consisting of spraying, ultrasonic spraying, spin coating, a doctor blade method, screen printing and ink-jet printing.

5. The method of claim 1, wherein, in the step (S3), the CIGS-based precursor thin film is formed by any one vacuum coating selected from group consisting of sputtering, simultaneous sputtering and evaporation.

6. The method of claim 1, wherein, in the step (S4), the heat treatment with selenium is performed at a temperature of 250 ∼ 600°C for 30 ∼ 120 minutes under a selenium atmosphere.

## Patentansprüche

1. Verfahren zur Herstellung einer CIGS-basierten Dünnschicht-Solarzelle, umfassend die Schritte:
Bilden einer Molybdänelektrode auf einem Na-freien Substrat (S1);
Bilden von Na-Versorgungsquellen auf Teilen der Oberfläche der Molybdän-Elektrode (S2);
Bilden eines CIGS-basierten Vorläufer-Dünnfilms auf der Molybdän-Elektrode (S3); und
Wärmebehandeln des CIGS-basierten Vorläufer-Dünnfilms mit Selen, um Na von den Na-Versorgungsquellen in den CIGS-basierten Vorläufer-Dünnfilm zu diffundieren,
wodurch ein CIGS-basierter Dünnfilm (S4) gebildet wird,
dadurch charakterisiert, dass in dem Schritt (S2) die Na-Versorgungsquellen Natriumhalogenid sind, gebildet auf einem Teil der Molybdänelektrode unter Verwendung einer Maske in einer Vakuumkammer.

2. Verfahren nach Anspruch 1, wobei in dem Schritt S1 das Na-freie Substrat ein Polymersubstrat ist, ausgewählt aus der Gruppe bestehend aus Polyimid (PI), Polyethylenterephthalat (PET), Polyethylennaphthalat (PEN), Polyethersulfon (PES) und aromatischer Polyester; einem Edelstahl (STS) -Substrat; einem Na-freien Glassubstrat; oder einem keramischen Substrat.

3. Verfahren nach Anspruch 1, wobei das Natriumhalogenid ausgewählt ist aus der Gruppe bestehend aus NaF, NaCl, NaBr und NaI.

4. Verfahren nach Anspruch 1, wobei in dem Schritt (S3) der CIGS-basierte Vorläufer-Dünnfilm durch irgendeine nicht-Vakuum-Beschichtung gebildet wird, ausgewählt aus der Gruppe bestehend aus Spritzen, Ultraschallspritzen, Schleuderbeschichten, Rakeltechnik, Siebdruck und Tintenstrahldruck.

5. Verfahren nach Anspruch 1, wobei in dem Schritt (S3) der CIGS-basierte Vorläufer-Dünnfilm durch irgendeine Vakuumbeschichtung gebildet wird, ausgewählt aus der Gruppe bestehend aus Sputtern, gleichzeitigem Sputtern und Verdampfen.

6. Verfahren nach Anspruch 1, wobei in dem Schritt (S4) das Wärmebehandeln mit Selen bei einer Temperatur von 250 ∼ 600 °C für 30 ∼ 120 Minuten unter einer Selenatmosphäre durchgeführt wird.

## Revendications

1. Procédé de fabrication de cellule solaire à couche mince à base de CIGS, comprenant les étapes de :
formation d'une électrode de molybdène sur un substrat sans Na (S1) ;
formation de sources d'alimentation de Na sur des parties de la surface de l'électrode de molybdène (S2) ;
formation d'une couche mince de précurseur à base de CIGS sur l'électrode de molybdène (S3) ; et
traitement thermique de la couche mince de précurseur à base de CIGS avec du sélénium pour diffuser Na depuis les sources d'alimentation de Na dans la couche mince de précurseur à base de CIGS, de manière à former une couche mince à base de CIGS (S4),
**caractérisé en ce que**, dans l'étape (S2), les sources d'alimentation de Na sont un halogénure de sodium formé sur une partie de l'électrode de molybdène en utilisant un masque dans une chambre à vide.

2. Procédé de la revendication 1, dans lequel, dans l'étape S1, le substrat sans Na est un substrat en polymère choisi dans le groupe constitué des polyimide (PI), poly(téréphtalate d'éthylène) (PET), poly(naphtalate d'éthylène) (PEN), polyéthersulfone (PES) et polyester aromatique ; un substrat en acier inoxydable (STS) ; un substrat en verre sans Na ; ou un substrat en céramique.

3. Procédé de la revendication 1, dans lequel l'halogénure de sodium est choisi dans le groupe constitué de NaF, NaCl, NaBr et Nal.

4. Procédé de la revendication 1, dans lequel, dans l'étape (S3),
la couche de précurseur à base de CIGS est formée d'un revêtement non-sous vide quelconque choisi dans le groupe constitué de la pulvérisation, la pulvérisation ultrasonore, le dépôt à la tournette, un procédé à la racle, la sérigraphie et l'impression à jet d'encre.

5. Procédé de la revendication 1, dans lequel, dans l'étape (S3), la couche de précurseur à base de CIGS est formée par un revêtement sous vide quelconque choisi dans le groupe constitué de la pulvérisation, la pulvérisation simultanée et l'évaporation.

6. Procédé de la revendication 1, dans lequel, dans l'étape (S4), le traitement thermique avec du sélénium est effectué à une température de 250 à 600°C pendant 30 à 120 minutes sous une atmosphère de sélénium.
